Europäisches Patentamt

European Patent Office

Office européen des brevets

(11) Numéro de publication: **0 162 755 B1**

# (12) FASCICULE DE BREVET EUROPEEN

(45) Date de publication de fascicule du brevet:
23.10.91

(51) Int. Cl.⁵: **H03K 17/66, H01F 7/18**

(21) Numéro de dépôt: 85400801.8

(22) Date de dépôt: 24.04.85

(54) **Circuit de commande d'un solenoide bistable.**

(30) Priorité: 09.05.84 FR 8407110

(43) Date de publication de la demande:
27.11.85 Bulletin 85/48

(45) Mention de la délivrance du brevet:
23.10.91 Bulletin 91/43

(84) Etats contractants désignés:
BE CH DE GB IT LI NL SE

(56) Documents cités:
DE-B- 1 129 529
GB-A- 1 231 640
GB-A- 1 462 190
US-A- 3 602 829
US-A- 4 388 571

(73) Titulaire: **TELEMECANIQUE**
**43-45, Boulevard Franklin Roosevelt**
**F-92504 Rueil-Malmaison Cedex(FR)**

(72) Inventeur: **Gaude, Maurice**
**Le Sappey en Chartreuse**
**F-38700 La Tronche(FR)**

(74) Mandataire: **Marquer, Francis et al**
**CABINET MOUTARD 35, avenue Victor Hugo**
**Résidence Champfleury**
**F-78180 Voisins-le-Bretonneux(FR)**

## Description

La présente invention concerne un circuit de commande d'un solénoïde bistable utilisable notamment, mais non exclusivement, dans un relais électromagnétique, dans un électroaimant de commande magnétique par exemple pour le verrouillage ou le déverrouillage d'une serrure, ou même dans une électrovanne bistable.

On rappelle qu'un solénoïde bistable se compose habituellement d'un circuit magnétique agissant sur une palette mobile pour l'amener dans l'une ou l'autre des deux positions stables suivantes :

- une première position R correspondant à une reluctance maximum du circuit magnétique, et
- une deuxième position S correspondant à une reluctance minimum du circuit magnétique.

Ces deux positions sont habituellement désignées par les termes "RESET" pour la première et "SET" pour la deuxième.

Le circuit magnétique permettant d'obtenir ces deux positions comprend généralement :

- un aimant permanent qui polarise le champ magnétique dans le circuit, en l'absence de champ extérieur, et
- au moins une bobine qui, lorsqu'elle est traversée par un courant, crée un champ qui se retranche ou s'ajoute à celui créé par l'aimant.

La commande de ces solénoïdes bistables s'effectue au moyen d'impulsions dont la durée doit être suffisante pour que la palette mobile ainsi que l'équipement mobile qui lui est associé, prennent la position stable recherchée.

Dans le cas où le solénoïde bistable ne comprend qu'une seule bobine, il est nécessaire d'inverser les polarités aux bornes de cette bobine pour obtenir les deux positions stables S et R recherchées.

Par contre dans le cas où le solénoïde comprend deux bobines montées en série et raccordées l'une à l'autre par un point milieu, l'impulsion destinée à obtenir la position S est appliquée aux bornes de l'une des bobines, tandis que l'impulsion destinée à obtenir la position R est appliquée aux bornes de l'autre bobine, le point milieu entre les deux bobines pouvant être relié en permanence à l'une des deux bornes de l'alimentation.

Le brevet US-A-4 388 571 propose un circuit de commande utilisable notamment pour un solénoïde, qui comprend un circuit d'inversion de la tension d'alimentation commandé en fonction de la comparaison d'une tension de détection avec deux tensions de référence.

Il s'avère que ces circuits, bien que couramment utilisés, présentent un certain nombre d'inconvénients.

Dans le cas où ils comprennent une seule bobine, ils nécessitent un croisement des connexions en vue d'obtenir, à partir des deux fils d'alimentation, une inversion du courant traversant la bobine.

Dans le cas où ils comprennent deux bobines avec point médian, ils font intervenir au moins trois bornes de raccordement et deux sources d'impulsions de commande pour obtenir les positions S et R.

En outre, ces solutions ne conviennent pas pour la réalisation de circuits de commande de structure matricielle, en effet :

- la solution à une bobine ne permet pas d'insérer dans le circuit de cette bobine une diode anti-retour,
- la solution à deux bobines nécessite, quant à elle, de doubler soit le nombre de lignes, soit le nombre de colonnes de la matrice.

L'invention a donc pour but de supprimer ces inconvénients. Elle propose à cet effet un circuit pour l'alimentation et la commande d'un solénoïde bistable du type comprenant un circuit magnétique comportant un aimant permanent qui polarise le champ magnétique dans le circuit, en l'absence de champ extérieur, et au moins une bobine qui, lorsqu'elle est traversée par un courant, crée un champ qui se retranche ou s'ajoute à celui créé par l'aimant, de manière à amener un organe mobile alternativement dans deux positions stables correspondant à une reluctance maximum et à une reluctance minimum du circuit magnétique, ledit circuit d'alimentation et de commande comprenant deux bornes d'entrée sur lesquelles peuvent être appliquées des impulsions de commande de même polarité,
caractérisé en ce que l'alimentation et la commande du solénoïde bistable s'effectuent par une liaison bifilaire reliant lesdites bornes d'entrée à un générateur apte à engendrer des impulsions de commande de deux types différents, à savoir : des impulsions d'un premier type qui présentent un premier niveau d'amplitude et sont destinées à et des impulsions d'un second type qui présentent un deuxième niveau d'amplitude différent du premier, et en ce que ledit circuit de commande est exclusivement alimenté par les susdites impulsions et comprend un circuit de discrimination des impulsions reçues par les deux bornes d'entrée en fonction de leur amplitude, ce circuit de discrimination pilotant un circuit de commutation apte à appliquer sélectivement les susdites impulsions sur les bornes d'excitation du solénoïde, de manière à ce que le circuit magnétique de ce solénoïde présente une reluctance minimum en réponse aux impulsions du premier type et une reluctance maximum, en réponse aux impulsions du deuxième type.

Bien entendu, le circuit de commande de solénoïde s'applique aussi bien aux solénoïdes comprenant une bobine qu'aux solénoïdes comprenant deux bobines séparées ou à point médian commun.

Par ailleurs, selon une autre caractéristique de l'invention le susdit circuit de discrimination comprend des moyens permettant de comparer l'amplitude des impulsions appliquées aux susdites bornes de commande par rapport à trois zones de tension de référence prédéterminées successives, à savoir :

- une première zone de tension incluant le niveau de tension des impulsions S du premier type,
- une deuxième zone de tension incluant le niveau de tension des impulsions R du second type, et
- une troisième zone de tension comprise entre les niveaux des deux types d'impulsions R, S, et dans laquelle l'amplitude desdites impulsions ne doit jamais se situer.

Dans ce cas, les moyens de commutation associés au circuit de discrimination commandent l'alimentation de la bobine, de manière à obtenir une reluctance minimum du circuit magnétique lorsque l'amplitude des impulsions fournies par le générateur est comprise dans la première zone de tension et une reluctance maximum du circuit magnétique lorsque l'amplitude des impulsions fournies par le générateur est comprise dans la deuxième zone de tension de référence.

Des modes de réalisation de l'invention seront décrits ci-après, à titre d'exemples non limitatifs, avec référence aux dessins annexés dans lesquels :

La figure 1 est un diagramme représentant la forme des deux types d'impulsions utilisées pour la commande du solénoïde ainsi que les trois zones de tension de référence utilisées par le circuit de commande.
La figure 2 est un schéma théorique d'un circuit de commande d'un solénoïde à une seule bobine.
La figure 3 est un schéma théorique d'un circuit de commande à deux bobines.
La figure 4 est un diagramme permettant d'illustrer l'incidence des temps de montée et de descente des impulsions de commande sur le fonctionnement des circuits représentés sur les figures 2 et 3.
La figure 5 est un mode de réalisation d'un circuit de commande d'un solénoïde à une bobine réalisé selon une technologie à transistors.
La figure 6 est un schéma partiel d'un circuit de commande du type de celui représenté figure 2 mais dans lequel l'écrêteur est réalisé d'une façon différente.
La figure 7 est un mode de réalisation d'un circuit de commande d'un solénoïde à deux bobines réalisé selon une technologie à transistors.
La figure 8 est le schéma d'un système de commande par commutateur statique et décodeur.
La figure 9 est le schéma d'un système de commande de type matriciel.

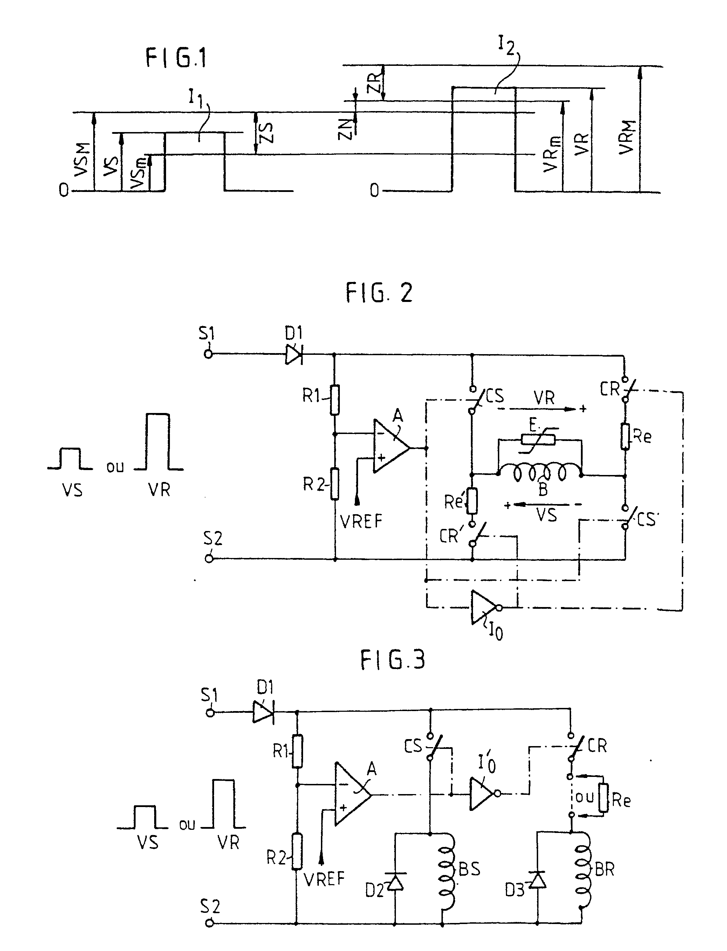

Comme précédemment mentionné, le dispositif de commande d'un solénoïde bistable selon l'invention nécessite l'emploi d'un générateur permettant de délivrer, sur ses bornes de commande S1, S2 des impulsions à deux niveaux d'amplitude, à savoir, un premier type d'impulsions S pour commander le passage du solénoïde à l'état stable S et un deuxième type d'impulsions R pour commander le passage du solénoïde à l'état stable R. Ces deux types d'impulsions se trouvent illustrés sur la figure 1 sur laquelle figurent :

- une impulsion $I_1$ de type S qui présente une amplitude VS située dans une zone de tension ZS comprise entre une tension VSm ("Vset minimum") et une tension $VS_M$ ("Vsetmaximum"), et
- une impulsion $I_2$ de type R qui présente une amplitude VR située dans une zone de tension ZR comprise entre une tension VRm ("VReset minimum") et une tension $VR_M$ ("VReset maximum").

La zone comprise entre la tension $VS_M$ et la tension VRm est une zone neutre ZN dans laquelle l'amplitude des impulsions ne doit jamais se situer car, dans cette zone, le discriminateur ne pourra pas déterminer avec certitude si l'impulsion est de type S ou de type R.

A titre d'exemple, la valeur nominale de l'amplitude des impulsions $I_1$ de type S pourra être égale à 12 V, la valeur VSm égale à 9 V et la valeur $VS_M$ égale à 14 Volts. De même la valeur nominale de l'amplitude des impulsions $I_2$ de type R pourra être égale à 24 Volts, la valeur VRm égale à 16 Volts et la valeur $VR_M$ égale à 30 Volts. La zone ZS aura alors une largeur de 5 Volts, la zone ZR une largeur de 14 Volts et la zone ZN une largeur de 2 V.

Dans l'exemple représenté sur la figure 2, le solénoïde bistable comprend une seule bobine B connectée aux bornes de commande S1 et S2 du circuit, par l'intermédiaire d'un circuit de commutation destiné à inverser le sens du courant circulant dans la bobine B selon le niveau d'amplitude des impulsions appliquées aux bornes S1 et S2.

A cet effet, chacune des extrémités de la bobine B se trouve raccordée aux bornes S1 et S2 du générateur par l'intermédiaire de deux commutateurs commandables, à savoir, les commutateurs CS et CR' pour l'une des extrémités de la bobine B et les commutateurs CR et CS' pour l'autre extrémité.

Ces commutateurs CS, CS', CR, CR' sont commandés par un circuit discriminateur de type comprenant un pont diviseur de tension constitué par deux résistances R1, R2 montées en série entre les deux bornes de commande S1 et S2 et dont le point de jonction est relié à la borne inverseuse d'un comparateur A dont l'entrée directe est portée à une tension de référence VREF.

La sortie de ce comparateur A est reliée, d'une part, par une liaison directe aux organes de commande des commutateurs CS et CS' et, d'autre part, par l'intermédiaire d'un inverseur Io aux organes de commande des commutateurs CR et CR'.

Ce circuit fait en outre intervenir une résistance R'e montée en série avec le commutateur CR', une résistance Re montée en série avec le commutateur CR, un écrêteur E monté en parallèle sur la bobine B et une diode D1 montée dans la liaison entre la borne de commande S1 et l'ensemble formé par le discriminateur et le circuit de commutation pilotant la bobine B.

Il convient de noter que dans ce circuit, la tension VSm, c'est-à-dire la tension minimum de la zone ZS, est déterminée par la tension minimum d'action de la bobine B provoquant le passage a l'état S du bistable. La tension VRm est quant à elle déterminée par la valeur de la tension VREF appliquée au comparateur.

Ainsi, le fonctionnement de ce circuit peut s'annoncer comme suit :
- dans le cas où le générateur d'impulsions délivre sur les bornes S1, S2 une impulsion de tension VS, la tension appliquée à l'entrée inverseuse du comparateur sera inférieure à la tension de référence VREF, de sorte que la sortie du comparateur A délivrera un signal de commande (état logique 1) entraînant la fermeture des commutateur CS et CS' et, en raison de l'inverseur I, l'ouverture des commutateurs CR, CR'. La bobine B se trouve donc portée à une tension VS orientée dans un un premier sens entraînant le passage à l'état S du solénoïde,
- dans le cas où le générateur d'impulsions délivre une impulsion de tension VR, la tension appliquée à l'entrée inverseuse du comparateur A sera supérieure ou égale à la tension de référence VREF, de sorte que la sortie de ce comparateur A délivrera un signal de commande (état logique O) entraînant l'ouverture des commutateurs CS et CS' et, en raison de l'inverseur I, la fermeture des commutateurs CR et CR'. La bobine se trouvera alors portée à une tension VR orientée dans un second sens entraînant le passage à l'état R du solénoïde.

Les résistances Re et Re' utilisées dans le circuit précédemment décrit jouent deux rôles. Tout d'abord elles permettent de protéger les commutateurs en cas de chevauchement dans la conduction CS, CR' ou CR, CS'. En outre, la bobine B étant définie pour agir à partir de la tension VSm, les résistances Re et Re', qui se trouvent alors en série, limitent le courant dans la bobine B lorsque l'on applique l'impulsion de tension VR, en particulier lorsque la tension VR est égale à la tension $VR_M$.

De même, la diode D1 utilisée joue deux rôles : elle assure une protection contre les inversions de polarité et elle sert de diode antiretour dans le cas d'une commande matricielle.

Le circuit de commande représenté sur la figure 3 fait intervenir une diode D1 et un discriminateur composé des résistances R1, R2 et d'un comparateur A montés d'une façon identique à celle de la figure 2. Toutefois à l'inverse du précédent, ce circuit comprend deux bobines BS et BR shuntées par deux diodes respectives D2, D3 et connectées par l'une de leurs extrémités à la borne de commande S2 et par leurs autres extrémités à la diode D1, par l'intermédiaire de deux commutateurs commandables respectifs CS et CR. Dans ce cas, la sortie du comparateur A se trouve directement reliée à l'organe de commande du commutateur CS et, par l'intermédiaire d'un inverseur I'o à l'organe de commande du commutateur CR. Selon ce circuit, l'émission d'une impulsion de tension VS provoquera la fermeture du commutateur CS et l'ouverture du commutateur CR de sorte que seule la bobine BS sera alimentée. Le solénoïde passera en conséquence à l'état S. A l'inverse, l'émission d'une impulsion de tension VR provoquera l'ouverture du commutateur CS et la fermeture du commutateur CR de sorte que seule la bobine BR sera alimentée. Le solénoïde passera donc à l'état R.

Il convient de noter que dans ce circuit, la tension VSm est déterminée par la tension minimum d'action de BS, et la tension VRm est déterminée par la tension de référence VREF. Toutefois la bobine BR doit être dimensionnée pour que son action fasse passer le solénoïde de l'état S à l'état R pour une tension VBR inférieure ou égale à VRm.

De préférence, la bobine BR peut être dimensionnée de manière à supporter la tension VRM sans consommer trop de courant. Toutefois, pour obtenir une telle limitation de courant il est éventuellement possible de disposer une résistance Re en série avec la bobine BR.

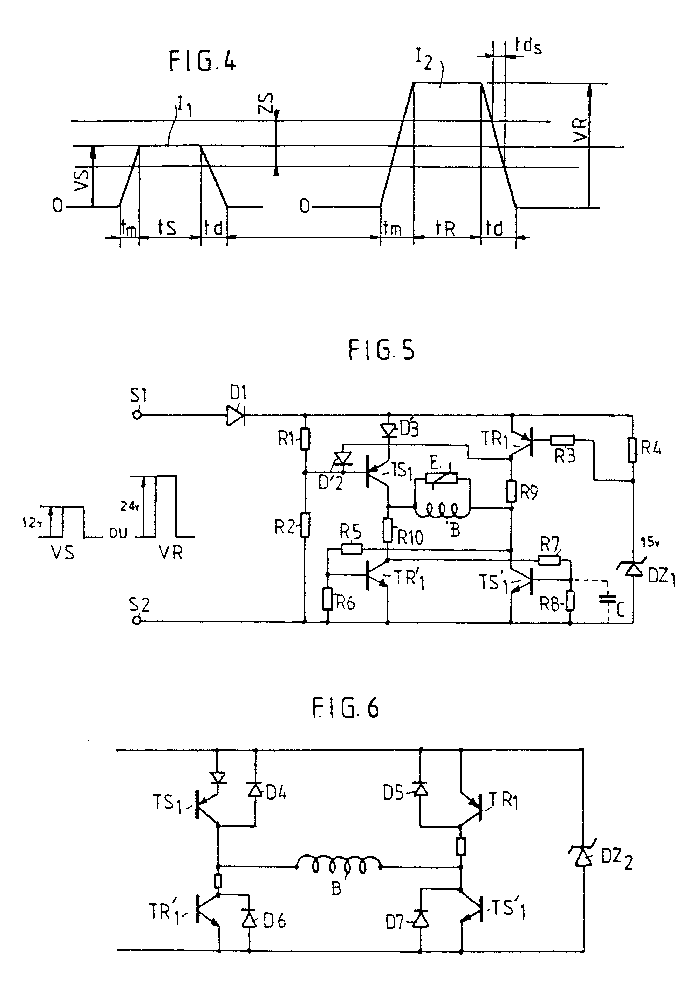

Dans les circuits représentés sur les figures 2 et 3, le temps de montée tm des impulsions de types S et R (figure 4) n'a pas d'influence sur le fonctionnement de ces circuits.

Par contre, le temps de descente td doit être inférieur au temps de réponse du solénoïde bistable. En effet, pendant la descente de l'impulsion de type R, la tension traverse la zone ZS pendant un temps tds.

Il est indispensable que le passage à l'état S du bistable ne soit pas activé pendant cette durée.

Ce résultat peut être obtenu en diminuant autant que possible le temps de descente td et/ou en augmentant le temps de réponse du solénoïde bistable à une impulsion de type S par exemple en retardant par une constante de temps Rc les fermetures du contacteur CS ou des contacteurs CS-CS'.

Ce problème peut être résolu en prévoyant des temps de réponse du solénoïde bistable à une impulsion de type S (temps de réponse $t_BS$) et à une impulsion de type R (temps de réponse $t_BR$) ainsi que des durées d'impulsions tS pour le type S et tR pour le type R qui répondent aux conditions suivantes :

$$2\,t_BS \leq tS \leq 3\,t_BS$$
$$2\,t_BS < tR \leq 3\,t_BR$$

avec

$t_BS \# T_BR \sim$ quelques ms
$tS \# tR \simeq 10$ ms

et

$$td \leq \frac{tR}{10}$$

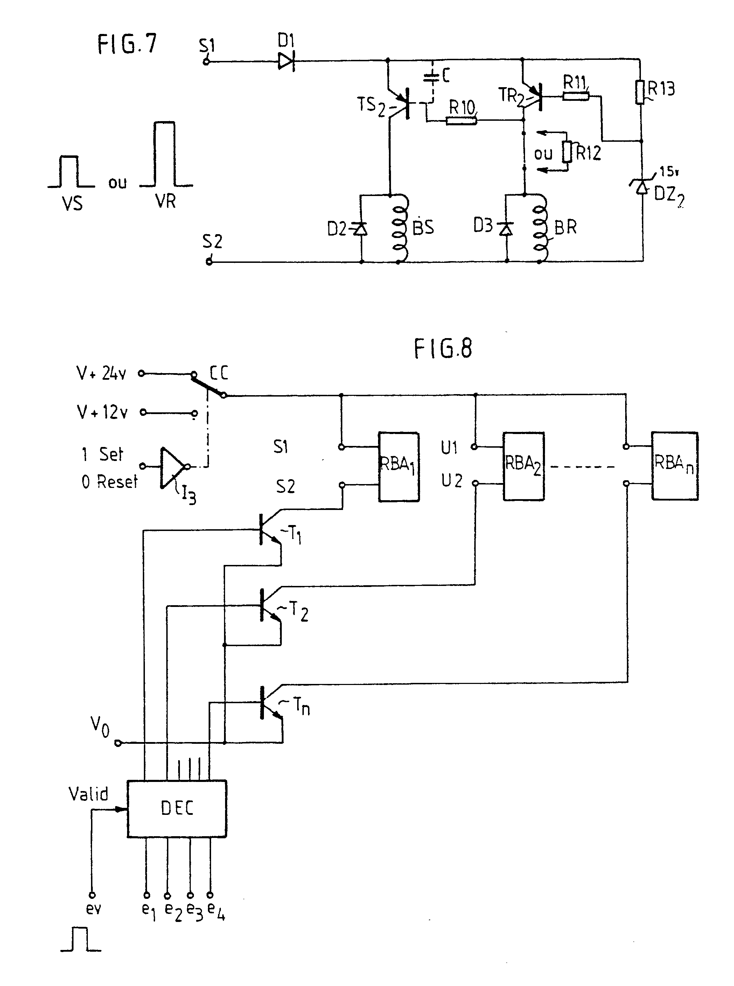

Les circuits de commande représentés figures 5 et 7 concernent des exemples de réalisation utilisant un nombre minimum de composants et, de ce fait, très économiques. Les transistors bipolaires utilisés dans ces circuits peuvent être remplacés, moyennant quelques légères modifications par des transistors MOS de puissance. La mise en oeuvre de ces circuits peut faire appel aux technologies de connectiques bien connues telles que, par exemple :

- à circuits imprimés rigides ou souples,
- à circuits hybrides couches épaisses,
- à circuit intégré spécifique de type Mos, C Mos ou bipolaire (CUSTOM).

Le circuit représenté sur la figure 5 s'applique à un solénoïde à une seule bobine B et présente une structure similaire à celle du circuit représenté figure 2. En conséquence, ce circuit comprend d'une façon analogue une diode D1, un pont diviseur de tension R1, R2, quatre transistors $TS_1$, $TS'_1$, $TR_1$, $TR'_1$ jouant respectivement le rôle des commutateurs commandables CS, CS', CR, CR', des résistances R9 et R10, analogues aux résistances Re, Re', qui se trouvent montées dans les circuits reliant les collecteurs des transistors TR' et TR aux deux extrémités de la bobine B, et un écrêteur E monté en parallèle sur la bobine B.

Les transistors $TS_1$ et $TR_1$ sont de type PNP et ont leurs émetteurs connectés à la diode D1, directement, pour ce qui concerne le transistor TR et par l'intermédiaire d'une diode D3' pour ce qui concerne le transistor $TS_1$.

Les transistors $TR'_1$ et $TS'_1$ sont de type NPN et sont connectés par leur émetteur à la borne de commande S2. Les collecteurs des transistors $TS_1$ et $TS'_1$ sont respectivement reliés aux deux extrémités de la bobine B.

La base du transistor $TS_1$ est connectée au point de jonction des résistances R1 et R2 du pont diviseur de tension ainsi qu'au collecteur du transistor $TR_1$ par l'intermédiaire d'une diode D'2.

La base du transistor $TR_1$ est connectée, par l'intermédiaire d'une résistance R3, au point de jonction d'une résistance R4 reliée par ailleurs à la diode D1 et d'une diode zener DZ1 par exemple de 15 Volts dont l'anode est reliée à la borne de commande S2.

La base du transistor $TR'_1$ est connectée au point de jonction de deux résistances R5 et R6 qui constituent un pont diviseur de tension entre le collecteur du transistor $TS'_1$ et la borne de commande S2.

La base du transistor $TS'_1$ est connectée au point de jonction de deux résistances R7 et R8 qui constituent un pont diviseur de tension entre le collecteur du transistor $TR'_1$ et la borne de commande S2. Un condensateur C destiné à retarder par une constante de temps la conduction du transistor $TS'_1$ est monté en parallèle sur la résistance R8. Selon ce circuit, lorsque le générateur d'impulsions délivre une impulsion de type S, par exemple de 12 Volts, le transistor $TS_1$ dont la base se trouve polarisée par le pont R1, R2 devient conducteur puis, après la charge du condensateur C le transistor $TS'_1$ dont la base se trouve polarisée par le circuit comprenant la diode D'3, le transistor $TS_1$ et les résistances R10, R7 et R8 devient à son tour conducteur.

Du fait de la conduction du transistor $TS'_1$, le transistor $TR'_1$ est maintenu à l'état bloqué. Il en est de même pour le transistor $TR_1$ dont la base se trouve portée à une tension voisine de sa tension émetteur.

La bobine B se trouve donc traversée par un courant qui circule dans un premier sens convenant pour amener le solénoïde bistable à l'état S.

Par contre, lorsque le générateur d'impulsions délivre une impulsion de type R par exemple de 24 Volts, la différence de potentiel émetteur/base du transistor $TR_1$ qui est alors d'environ de 9 Volts en raison de la diode zener $DZ_1$, est suffisante pour

provoquer la conduction du transistor TR$_1$. Cette conduction entraîne le blocage, grâce à la diode D'$_2$ du transistor TS$_1$ et par l'intermédiaire du circuit comprenant les résistances R9, R5 et R6, la conduction du transistor TR'$_1$. La bobine B se trouve donc traversée par un courant qui circule dans un second sens convenant pour amener le solénoïde bistable à l'état R.

Il apparaît donc que dans ce mode de réalisation la tension VRm est déterminée par la diode zener DZ$_1$.

Bien entendu, l'invention ne se limite pas aux modes de réalisation précédemment décrits. Ainsi, par exemple, l'écrêteur E pourrait être remplacé, comme représenté sur la figure 6, par quatre diodes D$_4$, D$_5$, D$_6$ et D$_7$ montées en antiparallèle sur les transistors TS$_1$, TS'$_1$ et TR$_1$, TR'$_1$ et une diode zener DZ$_2$ connectée entre la diode D$_1$ et la borne de commande S2.

Le circuit représenté figure 7 comprend deux bobines BS et BR connectées aux bornes de l'alimentation par l'intermédiaire de deux transistors TS$_2$ et TR$_2$ respectifs et d'une diode commune D$_1$. La base du transistor TS$_2$ est reliée à son émetteur par l'intermédiaire d'un condensateur C et au collecteur du transistor TR$_2$ par l'intermédiaire d'une résistance R$_{10}$. La base du transistor TR$_2$ est quant à elle connectée au point de jonction d'une résistance R$_{13}$ reliée aux collecteurs des transistors TS$_2$ et TR$_2$ et d'une diode zener DZ$_2$ reliée à la borne de commande S$_2$.

Dans le circuit reliant le collecteur du transistor TR$_2$ à la bobine B$_R$ peut en outre être disposée une résistance R$_{12}$.

Ainsi, lorsque le générateur d'impulsions délivre une impulsion de type S, le transistor TS$_2$ est rendu conducteur après une légère temporisation (polarisation de sa base par le circuit C, R$_{10}$, BR) tandis que le transistor TR$_2$ demeure bloqué du fait que la tension de l'impulsion est inférieure à la tension de seuil de la diode zener DZ$_2$. Seule la bobine BS sera donc traversée par un courant.

Par contre, lorsque le générateur d'impulsions délivre une impulsion de type R, le transistor TR$_2$ devient conducteur et provoque le blocage du transistor TS$_2$ (polarisation de la base par R$_{13}$, DZ$_2$ et R$_{11}$), seule la bobine BR sera donc traversée par un courant.

Comme précédemment mentionné, les circuits de commande selon l'invention peuvent avantageusement équiper des relais bistables utilisables dans des circuits de commande classiques.

La figure 8 montre un exemple de réalisation d'un circuit de commande par commutateur statique et décodeur qui comprend une pluralité de relais bistables actifs RBA$_1$, RBA$_2$ ... RBA$_n$. Ces relais utilisent chacun un circuit de commande non représentés tels que ceux précédemment décrits qui présentent chacun deux bornes de commande.

Les bornes S$_1$ de ces relais sont connectées à un générateur d'impulsions de type S et R qui comprend, de façon classique, un commutateur CC raccordé à deux sources de tension, l'une à une tension de V + 12 Volts pour les impulsions de type S et l'autre de V + 24 Volts pour les impulsions de type R, et commandé par un circuit inverseur I$_3$ recevant un signal logique à deux niveaux, à savoir un signal logique de type S (par exemple de niveau 1) et un signal logique de type R (par exemple de niveau 0).

Les bornes S$_2$ des relais RBA$_1$ ... RBA$_n$ sont reliées à une source de tension de référence V$_o$, par exemple la masse, par l'intermédiaire de transistors respectifs T$_1$, T$_2$ ... T$_n$, dont les bases sont pilotées par un décodeur DEC. Ce décodeur DEC comprend entre entrée logique par exemple à quatre bornes e$_1$, e$_2$, e$_3$, e$_4$ et une entrée de validation ev qui permet notamment de définir la durée des impulsions appliquées aux relais bistables RBA$_1$, RBA$_2$ ... RBA$_n$.

Ainsi, pour une combinaison logique déterminée appliquée aux entrées e$_1$, e$_2$, e$_3$, e$_4$ du décodeur DEC et pendant la durée de l'impulsion de validation, un relais bistable RBA correspondant sera soumis à une impulsion dont le type sera défini par le niveau logique appliqué au commutateur CC.

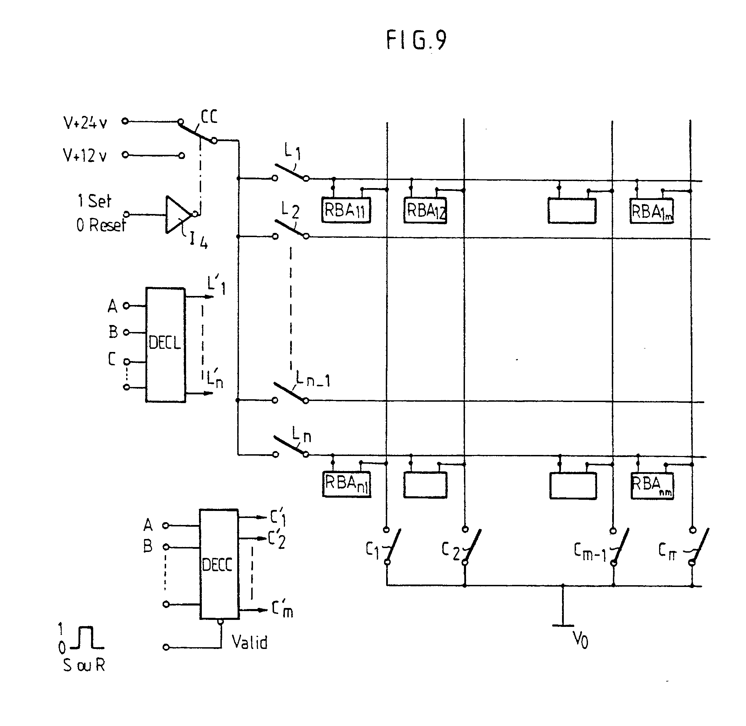

La figure 9 illustre un exemple d'application de l'invention à la réalisation d'un système de commande matricielle.

Ce système comprend, de façon classique, un réseau maillé de conducteur à $\underline{n}$ lignes et $\underline{m}$ colonnes aux intersections desquelles sont branchés, de façon classique, les relais bistables actifs :

$$\begin{array}{ccc} RBA_{11} & \cdots & RBA_{1m} \\ \bullet & & \bullet \\ \bullet & & \bullet \\ \bullet & & \bullet \\ RBA_{n1} & \cdots & RBA_{nm} \end{array}$$

Chacune des lignes de ce réseau se trouve connectée, par l'intermédiaire d'un commutateur L$_1$, L$_2$ ... L$_{n-1}$, L$_n$, à un générateur d'impulsions de type S et R qui comprend, de façon classique, un commutateur CC raccordé à deux sources de tension, l'une à V + 12 Volts pour les impulsions de type S et l'autre de V + 24 Volts pour les impulsions de type R. Ce commutateur est commandé par un inverseur I$_4$ recevant un signal logique à deux niveaux, à savoir : un signal logique de type S (par exemple de niveau 1) et un signal logique de type R (par exemple de niveau 0).

Par ailleurs, les colonnes de ce réseau sont connectées à la tension de référence $V_o$, par exemple OV, par l'intermédiaire de commutateurs $C_1$, $C_2$ ... $C_{m-1}$, $C_m$.

Les commutateurs de ligne $L_1$, $L_2$ ... $L_{n-1}$, $L_n$ sont pilotés par un décodeur de ligne DECI qui comprend autant de sorties $L'_1$, $L'_2$ ... $L'_n$ qu'il y a de commutateurs $L_1$, $L_2$ ... $L_n$.

De même, les commutateurs de colonne $C_1$, $C_2$ ... $C_n$ sont pilotés par un décodeur de colonne DECC qui comprend autant de sorties $C'_1$, $C'_2$ ... $C'_n$ qu'il y a de commutateurs $C_1$, $C_2$ ... $C_n$.

Ces décodeurs de ligne DECL et de colonne DECC reçoivent respectivement sur leurs entrées des signaux logiques d'adressage de ligne et de colonne.

En outre, le décodeur de colonne DECC comprend une entrée de validation ev qui permet notamment de définir le temps des impulsions de type S et de type R appliquées aux relais bistables RBA.

Ainsi, pour une adresse de ligne donnée appliquée au décodeur de ligne et pour une adresse de colonne donnée appliquée au décodeur d'adresse et pendant la durée du signal de validation, un relais bistable du réseau sera activé selon l'état du commutateur CC, par un signal de type S ou par un signal de type R.

Il convient de noter que, dans ce type d'application, des diodes anti-retour $D_1$ devront être prévues dans chaque relais bistable RBA.

L'avantage du système précédemment décrit consiste en ce qu'il peut faire intervenir un grand nombre de relais à fonctionnement tout ou rien. Il est donc particulièrement adapté dans le domaine des automatismes industriels.

**Revendications**

1. Circuit pour l'alimentation et la commande d'un solénoïde bistable du type comprenant un circuit magnétique comportant un aimant permanent qui polarise le champ magnétique dans le circuit, en l'absence de champ extérieur, et au moins une bobine (B) qui, lorsqu'elle est traversée par un courant, crée un champ qui se retranche ou s'ajoute à celui créé par l'aimant, de manière à amener un organe mobile alternativement dans deux positions stables (R) et (S) correspondant à une reluctance maximum et à une reluctance minimum du circuit magnétique, ledit circuit d'alimentation et de commande comprenant deux bornes d'entrée ($S_1$, $S_2$) sur lesquelles peuvent être appliquées des impulsions de commande de même polarité, caractérisé en ce que l'alimentation et la commande du solénoïde bistable s'effectuent par une liaison bifilaire reliant lesdites bornes d'entrée ($S_1$, $S_2$) à un générateur apte à engendrer des impulsions de commande de deux types différents ($I_1$, $I_2$), à savoir : des impulsions ($I_1$) d'un premier type qui présentent un premier niveau d'amplitude (VS), et des impulsions ($I_2$) d'un second type qui présentent un deuxième niveau d'amplitude (VR) différent du premier et en ce que ledit circuit de commande est exclusivement alimenté par les susdites impulsions ($I_1$, $I_2$) et comprend un circuit de discrimination des impulsions reçues par les deux bornes d'entrée en fonction de leur amplitude, ce circuit de discrimination (A, $R_1$, $R_2$) pilotant un circuit de commutation (CS, CR, CS', CR') apte à appliquer sélectivement les susdites impulsions ($I_1$, $I_2$) sur les bornes d'excitation du solénoïde, de manière à ce que le circuit magnétique de ce solénoïde présente une reluctance minimum en réponse aux impulsions ($I_1$) du premier type et une reluctance maximum, en réponse aux impulsions ($I_2$) du deuxième type.

2. Circuit selon la revendication 1, caractérisé en ce que le susdit circuit de discrimination ($R_1$, $R_2$, A) comprend des moyens (A), permettant de comparer l'amplitude des impulsions appliquées sur les bornes ($S_1$, $S_2$) par rapport à trois zones de tension de référence prédéterminées successives, à savoir :

   - une première zone de tension incluant le niveau de tension des impulsions (S) du premier type,
   - une deuxième zone de tension incluant le niveau de tension des impulsions (R) du second type, et
   - une troisième zone de tension comprise entre les niveaux des deux types d'impulsions (R, S) et dans laquelle l'amplitude desdites impulsions ne doit jamais se situer, et

   en ce que ledit circuit de discrimination ($R_1$, $R_2$, A) agit sur les moyens de commutation (CS, CS', CR, CR') commandant l'alimentation de la bobine (B) de manière à obtenir une reluctance minimum du circuit magnétique lorsque l'amplitude des impulsions appliquées sur les bornes ($S_1$, $S_2$) est comprise dans la première zone de tension et une reluctance maximum du circuit magnétique lorsque l'amplitude des impulsions appliquées sur les bornes ($S_1$, $S_2$) est comprise dans la deuxième zone de tension de référence.

3. Circuit d'un solénoïde bistable comprenant une seule bobine (B), caractérisé en ce que ladite bobine (B) est connectée aux bornes de commande ($S_1$, $S_2$) du circuit par l'intermédiaire d'un circuit de commutation (CS, CS', CR, CR') apte à inverser le sens du courant circulant dans la bobine (B) selon le niveau des impulsions.

4. Circuit selon la revendication 3,
caractérisé en ce que ledit circuit de commutation comprend un premier et un deuxième commutateurs commandables (CS, CR') reliant respectivement l'une des extrémités de la bobine (B) aux deux bornes de commande ($S_1$, $S_2$) du circuit, et un troisième et un quatrième commutateurs commandables (CR et CS') reliant respectivement l'autre extrémité de la bobine (B) aux deux bornes ($S_1$, $S_2$), et en ce que lesdits commutateurs (CS, CS', CR, CR') sont commandés par un circuit discriminateur comprenant un pont diviseur de tension constitué par deux résistances ($R_1$, $R_2$) montées en série entre les deux bornes de commande ($S_1$, $S_2$) et dont le point de jonction est relié à l'entrée d'un comparateur (A) qui compare la tension audit point de jonction à une tension de référence (VREF), la sortie de ce comparateur (A) étant reliée, d'une part, par une liaison directe, aux organes de commande des premier et quatrième commutateurs (CS, CS') et, d'autre part, par l'intermédiaire d'un circuit inverseur (Io) aux organes de commande des deuxième et troisième commutateurs (CR) et (CR').

5. Circuit selon la revendication 4,
caractérisé en ce qu'il comprend en outre des résistances (R'e) et (Re) respectivement montées en série avec les deuxième et troisième commutateurs (C'R) et (CR).

6. Circuit selon l'une des revendications précédentes,
caractérisé en ce qu'il comprend en outre un écrêteur (E) monté en parallèle sur la bobine (B).

7. Circuit selon l'une des revendications précédentes,
caractérisé en ce qu'il comprend une première diode ($D_1$) montée dans la liaison entre l'une ($S_1$) des deux bornes de commande et l'ensemble formé par le discriminateur et le circuit de commutation pilotant la bobine (B).

8. Circuit selon l'une des revendications 4 à 7, dans lequel les sudits commutateurs commandables (CS, CS', CR, CR') consistent en des premier, deuxième, troisième et quatrième transistors ($TS_1$, $TS'_1$, $TR_1$, $TR'_1$),

caractérisé en ce que :
- le premier transistor ($TS_1$) est de type PNP et a son émetteur connecté à la première diode ($D_1$) par l'intermédiaire d'une deuxième diode ($D'_3$),
- le troisième transistor ($TR_1$) est de type PNP et a son émetteur directement connecté à la première diode ($D_1$),
- les deuxième et quatrième transistors ($TS'_1$) et ($TR'_1$) sont de type NPN et sont connectés par leurs émetteurs à la borne de commande ($S_2$) du circuit,
- les collecteurs des premier et troisième transistors ($TS_1$) et ($TS'_1$) sont respectivement reliés aux extrémités de la bobine (B),
- les collecteurs des deuxième et quatrième transistors ($TR_1$) et ($TR'_1$) sont respectivement reliés aux deux extrémités de la bobine (B) par deux résistances respectives ($R_9$, $R_{10}$),
- la base du premier transitor ($TS_1$) est connectée au point de jonction des résistances ($R_1$, $R_2$) du susdit pont diviseur de tension ainsi qu'au collecteur du troisième transistor ($TR_1$) par l'intermédiaire d'une troisième diode ($D'_2$),
- la base du troisième transistor ($TR_1$) est connectée par l'intermédiaire d'une résistance ($R_3$) au point de jonction d'une résistance ($R_4$) reliée par ailleurs à la diode ($D_1$) et d'une diode Zener ($DZ_1$) dont l'anode est reliée à la borne de commande ($S_2$),
- la base du second transistor ($TS'_1$) est connectée au point de jonction de deux résistances ($R_7$) et ($R_8$) qui constituent un pont diviseur de tension entre le collecteur du quatrième transistor ($TR'_1$) et la borne de commande ($S_2$),
- un condensateur (C) est monté en parallèle sur la résistance ($R_8$).

9. Circuit selon l'une des revendications 4 à 8, caractérisé en ce que le susdit écrêteur consiste en quatre diodes ($D_4$, $D_5$, $D_6$) montées respectivement en antiparallèle sur les susdits premier, deuxième, troisième et quatrième transistors ($TS_1$, $TS'_1$, $TR_1$, $TR'_1$).

10. Circuit selon la revendication 1 pour l'alimentation et la commande d'un solénoïde bistable comprenant deux bobines (BS, BR),
caractérisé en ce que ces deux bobines ($B_1$, $B_2$) sont connectées aux bornes ($S_1$, $S_2$) du circuit par l'intermédiaire d'un circuit de commutation apte à alimenter l'une ou l'autre des bobines (BS, BR), selon le niveau des impulsions appliquées aux bornes de commande (S₁, S₂).

**11.** Circuit selon la revendication 10,
caractérisé en ce que le susdit circuit de commutation comprend deux commutateurs commandables (CS) et (CR) montés respectivement en série avec les bobines (BS) et (BR), et en ce que lesdits commutateurs commandables (CS) et (CR) sont commandés par un circuit discriminateur comprenant un pont diviseur de tension constitué par deux résistances (R₁, R₂) montées en série entre les deux bornes de commande (S₁, S₂), et dont le point de jonction est relié à l'entrée d'un comparateur (A) qui compare la tension audit point de jonction à une tension de référence (VREF), la sortie de ce comparateur (A) étant reliée, d'une part, par une liaison directe à l'organe de commande de l'un des deux commutateurs commandables (CS), et à l'organe de commande de l'autre commutateur commandable (CR) par l'intermédiaire d'un inverseur (I'o).

**12.** Circuit selon l'une des revendications 10 et 11, caractérisé en ce qu'une diode (D₂, D₃) est montée en parallèle sur chacune des bobines (BR, BS).

**13.** Circuit selon l'une des revendications 10 à 12, caractérisé en ce qu'une résistance (Re) est montée en série avec la bobine (BR).

**14.** Circuit selon l'une des revendications 10 à 13, caractérisé en ce qu'il comprend une diode (D₁) montée dans la liaison entre l'une (S₁) des deux bornes de commande et l'ensemble formé par le discriminateur et le circuit de commutation pilotant les bobines (BS) et (BR).

**15.** Circuit selon l'une des revendications 10 à 14, caractérisé en ce que les deux susdites bobines (BS) et (BR) sont connectées aux susdites bornes de commande par l'intermédiaire de deux transistors (TS₂) et (TR₂) respectifs et d'une diode commune (D₁),
en ce que la base du transistor (TS₂) est reliée à son émetteur par l'intermédiaire d'un condensateur (C) et au collecteur du transistor (TR'₂) par l'intermédiaire d'une résistance (R₁₀), et
en ce que la base du transistor (TR₂) est connectée au point de jonction d'une résistance (R₁₃) reliée aux collecteurs des transistors (TS₂) et (TR₂) et d'une diode Zener (DZ₂) reliée à la borne de commande (S₂).

**Claims**

**1.** Control and supply circuit for a bistable solenoid of the type including a magnetic circuit comprising a permanent magnet which polarizes the magnetic field inside the circuit in the absence of any external field, and at least one coil (B) which, when crossed by a current, creates a field which entrenches itself or is added to the one created by the magnet in such a way as to lead a mobile device alternately into two stable positions (R) and (S) corresponding to a maximum reluctance and a minimum reluctance of the magnetic circuit, said control and supply circuit including two input terminals (S₁, S₂) to which can be applied control pulses of same polarity,
characterized in that the supply and the control of the bistable solenoid are obtained by means of a bifilar connection connecting said input terminals (S₁, S₂) to a generator capable of generating control pulses of two different types (I₁, I₂), namely : pulses (I₁) of a first type which present a first level of amplitude (VS), and pulses (I₂) of a second type which present a second level of amplitude (VR) different from the first one, and in that said control circuit is fed only by said pulses (I₁, I₂) and comprises a circuit for discriminating the pulses received by the two input terminals according to their amplitude, said discrimination circuit (A, R₁, R₂) monitoring a switching circuit (CS, CR, CS', CR') capable of applying selectively said pulses (I₁, I₂) on the enabling terminals of the solenoid, so that the magnetic circuit of this solinoid presents a minimum reluctance in response to pulses (I₁) of the first type and a maximum reluctance, in response to pulses (I₂) of the second type.

**2.** Circuit according to claim 1,
characterized in that the above-mentioned discrimination circuit (R₁, R₂, A) includes means (A) enabling the amplitude of pulses applied to the terminals (S₁, S₂) to be compared with three successive predetermined reference voltage zones, namely :
- a first voltage zone including the voltage level of pulses (S) of the first type,
- a second voltage zone including the voltage level of pulses (R) of the second type, and
- a third voltage zone included between the levels of the two types of pulses (R, S) and in which the amplitude of the said pulses must never be situated,
and in that the said discrimination circuit (R₁, R₂, A) acts on the switching means (CS, CS', CR, CR') controlling feed of the coil (B) so as to obtain a minimum reluctance of the magnetic circuit when the amplitude of the pulses applied to the terminals ($S_1$, $S_2$) is included in a first voltage zone and a maximum reluctance of the magnetic circuit when the amplitude of the pulses applied to the terminals ($S_1$, $S_2$) is included in the second reference voltage zone.

3. Circuit for a bistable solenoid comprising a single coil (B),
characterized in that the said coil (B) is connected to the control terminals ($S_1$, $S_2$) of the circuit by means of a switching circuit (CS, CS', CR, CR') suitable for inverting the direction of the current circulating inside the coil (B), according to the level of pulses.

4. Circuit according to claim 3,
characterized in that the said switching circuit includes a first and second controllable switch (CS, CR') respectively connecting one of the extremities of the coil (B) to two control terminals ($S_1$, $S_2$) of the circuit and a third and fourth controllable switch (CR and CS') respectively connecting the other extremity of the coil (B) to the two terminals ($S_1$, $S_2$), and in that the said switches (CS, CS', CR, CR') are controlled by a discriminating circuit including a voltage divider bridge constituted by two resistances ($R_1$, $R_2$) connected in series between the two control terminals ($S_1$, $S_2$) and whose connection point is connected to the input of a comparator (A) which compares the voltage at the said connection point with a reference voltage (VREF), the output of this comparator (A) being connected firstly by direct link to the control devices of the first and fourth control switches (CS, CS') and secondly by means of an inverter circuit (Io) to the control devices of the second and third switches (CR) and (CR').

5. Circuit according to claim 4,
characterized in that it includes in addition the resistances (R'e) and (Re) respectively connected in series with the second and third switches (C'R) and (CR).

6. Circuit according to one of the preceding claims,
characterized in that it includes in addition an amplitude limiter (E) mounted in parallel on the coil (B).

7. Circuit according to one of the preceding claims,
characterized in that it includes a first diode ($D_1$) mounted in the link between one ($S_1$) of the two control terminals and the unit formed by the discriminator and the switching circuit monitoring the coil (B).

8. Circuit according to one of the claims 4 to 7, in which the above-mentioned controllable switches (CS, CS', CR, CR') consist of first, second, third and fourth transistors ($TS_1$, $TS'_1$, $TR_1$, $TR'_1$),
characterized in that :
   - the first transistor ($TS_1$) is of the PNP type and has its transmitter connected to the first diode ($D_1$) by means of a second diode ($D'_3$),
   - the third transistor ($TR_1$) is of the type PNP and has its transmitter connected directly to the first diode ($D_1$),
   - the second and fourth transistors ($TS'_1$) and ($TR'_1$) are of the type NPN and are connected by their transmitters to the control terminal ($S_2$) of the circuit,
   - the collectors of the first and third transistors ($TS_1$) and ($TS'_1$) are respectively connected to the extremities of the coil (B),
   - the collectors of the second and fourth transistors ($TR_1$) and ($TR'_1$) are connected respectively to the two extremities of the coil (B) by two respective resistances ($R_9$, $R_{10}$),
   - the base of the first transistor ($TS_1$) is connected to the connection point of the resistances ($R_1$, $R_2$) of the above-mentioned voltage divider bridge as well as to the collector of the third transistor ($TR_1$) by means of a third diode ($D'_2$),
   - the base of the third transistor ($TR_1$) is connected by means of a resistance ($R_3$) to the connection point of a resistance ($R_4$) itself connected to the diode ($D_1$) and of a Zener diode ($DZ_1$), whose anode is connected to the control terminal ($S_2$),
   - the base of the second transistor ($TS'_1$) is connected to the connection point of two resistances ($R_7$) and ($R_8$) which constitute a voltage divider bridge between the collector of the fourth transmitter ($TR'_1$) and the control terminal ($S_2$),
   - a capacitor (C) is mounted in parallel on the resistance ($R_8$).

9. Circuit according to one of the claims 4 to 8, characterized in that the above-mentioned amplitude limiter consists of four diodes ($D_4$, $D_5$, $D_6$) respectively mounted in antiparallel fashion on the above-mentioned first, second, third and fourth transistors ($TS_1$, $TS'_1$, $TR_1$, $TR'_1$).

10. Circuit according to claim 1, for the supply and the control of a bistable solenoid comprising two coils (BS, BR),
characterized in that these two coils (B$_1$, B$_2$) are connected to the terminals (S$_1$, S$_2$) of the circuit by means of a switching circuit suitable for feeding one or other of the coils (BS, BR) according to the level of pulses applied to the control terminals (S$_1$, S$_2$).

11. Circuit according to claim 10,
characterized in that the above-mentioned switching circuit includes two controllable switches (CS) and (CR) respectively connected in series with the coils (BS) and (BR) and in that the said controllable switches (CS) and (CR) are controlled by a discriminator circuit including a voltage divider bridge constituted by two resistances (R$_1$, R$_2$) connected in series between the two control terminals (S$_1$, S$_2$) and whose connection point is connected to the input of a comparator (A) which compares the voltage at the said connection point with a reference voltage (VREF), the output of this comparator (A) being connected firstly by a direct link to the control device of one of the two controllable switches (CS) and secondly to the control device of the other controllable switch (CR) by means of an inverter (I'o).

12. Circuit according to one of the claims 10 and 11,
characterized in that a diode (D$_2$, D$_3$) is mounted in parallel on each of the coils (BR, BS).

13. Circuit according to one of the claims 10 to 12,
characterized in that a resistance (Re) is connected in series with the coil (BR).

14. Circuit according to one of the claims 10 to 13,
characterized in that it includes a diode (D$_1$) mounted in the link between one (S$_1$) of the two control terminals and the unit formed by the discriminator and the switching circuit monitoring the coils (BS) and (BR).

15. Circuit according to one of the claims 10 to 14,
characterized in that the two above-mentioned coils (BS) and (BR) are connected to the above-mentioned control terminals by means of two transistors (TS$_2$) and (TR$_2$) respectively and a common diode (D$_1$), and in that the base of the transistor (TS$_2$) is connected to its transmitter by means of a capacitor (C) and to the collector of the transistor (TR'$_2$) by means of a resistance (R$_{10}$) and in that the base of the transistor (TR$_2$) is connected to the connection point of a resistance (R$_{13}$) connected to the

collectors of transistors (TS$_2$) and (TR$_2$) and of a Zener diode (DZ$_2$) connected to the control terminal (S$_2$).

**Patentansprüche**

1. Steuer- und Versorgungsschaltung für eine bistabile Zylinderspule des Typs mit einer Magnetschaltung, die einen permanenten Magneten aufweist, welcher das Magnetfeld in der Schaltung bei Nichtvorhandensein eines äusseren Feldes polarisiert und mindestens eine Spule (B), die, wenn sie von Strom durchflossen wird, ein Feld erzeugt, welches sich von dem vom Magneten erzeugten Feld abzieht oder sich ihm hinzufügt, um ein bewegliches Organ wechselweise in zwei stabile, der maximalen und der minimalen Reluktanz der Magnetschaltung entsprechende, Positionen (R) und (S) zu bewegen, wobei besagte Steuer- und Versorgungsschaltung zwei Eingangsklemmen (S$_1$, S$_2$) aufweist, an die Steuerimpulse gleicher Polarität angelegt werden können,
dadurch gekennzeichnet, dass die Versorgung und Steuerung der bistabilen Zylinderspule durch einen zweiadrigen Anschluss erfolgt, welcher besagte Eingangsklemmen (S$_1$, S$_2$) an einen Generator anschliesst, welcher zwei verschiedene Arten von Steuerimpulsen (I$_1$, I$_2$) erzeugen kann, nämlich :
- Impulse der ersten Art (I$_1$), mit einer ersten Amplitude (VS) und
- Impulse der zweiten Art (I$_2$), mit einer zweiten, von der ersten verschiedenen, Amplitude (VR),
und dass besagte Steuerschaltung ausschliesslich von besagten Impulsen (I$_1$, I$_2$) gespeist wird und eine Schaltung zur Diskriminierung der von den beiden Eingangsklemmen empfangenen Impulse je nach deren Amplitude aufweist und diese Diskriminierschaltung (A, R$_1$, R$_2$) einen Umschaltkreis (CS, CR, CS', CR') beaufschlagt, der selektiv besagte Impulse (I$_1$, I$_2$) an die Erregungsklemmen der Zylinderspule übertragen kann, sodass die Magnetschaltung dieser Spule nach Übermittlung von Impulsen der ersten Art (I$_1$) eine minimale Reluktanz hat und eine maximale Reluktanz nach Empfang von Impulsen der zweiten Art (I$_2$).

2. Schaltung nach Anspruch 1,
dadurch gekennzeichnet, dass besagte Diskriminierschaltung (R$_1$,R$_2$, A) Mittel aufweist, um die Amplitude der an die Klemmen (S$_1$, S$_2$) angelegten Impulse im Verhältnis zu drei bestimmten aufeinanderfolgenden Referenzspannungsbereichen zu vergleichen, nämlich :
- einem ersten Spannungsbereich, der den Spannungswert der Impulse der ersten Art (S) umfasst,

- einem zweiten Spannungsbereich, welcher den Spannungswert der Impulse der zweiten Art (R) umfasst, und

- einem dritten, zwischen den Werten der beiden Impulsarten (R, S) gelegenem Spannungsbereich, in dem sich die Amplitude der besagten Impulse nie befinden darf,

und dass besagte Diskriminierschaltung ($R_1$, $R_2$, A) auf die Umschaltmittel (CS, CS', CR, CR') wirkt, welche die Speisung der Spule (B) steuern, um so eine minimale Reluktanz der Magnetschaltung zu erreichen, wenn sich die an die Klemmen ($S_1$, $S_2$) angelegte Impulsamplitude im ersten Bereich befindet und eine maximale Reluktanz der Magnetschaltung, wenn sich die an die Klemmen ($S_1$, $S_2$) angelegte Impulsamplitude im zweiten Referenzspannungsbereich befindet.

3. Schaltung für eine bistabile Zylinderspule, mit einer einzigen Spule (B),
dadurch gekennzeichnet, dass besagte Spule (B) an die Steuerklemmen ($S_1$, $S_2$) der Schaltung angeschlossen ist, durch einen Umschaltkreis (CS, CS', CR, CR'), der die Richtung des in der Spule (B) fliessenden Stroms je nach dem Impulswert wenden kann.

4. Schaltung nach Anspruch 3,
dadurch gekennzeichnet, dass besagter Umschaltkreis einen ersten und einen zweiten steuerbaren Schalter (CS, CR') aufweist, die jeweils eines der Enden der Spule (B) mit den beiden Steuerklemmen ($S_1$, $S_2$) der Schaltung verbinden und einen dritten und vierten steuerbaren Schalter (CR und CS'), die jeweils das andere Ende der Spule (B) mit den beiden Klemmen ($S_1$, $S_2$) verbinden und dass besagte Schalter (CS, CS', CR, CR') von einer Diskriminierschaltung gesteuert werden, welche eine Spannungsteilerbrücke aufweist, die von zwei Widerständen ($R_1$, $R_2$) gebildet wird, welche in Serie zwischen den beiden Steuerklemmen ($S_1$, $S_2$) angeordnet sind und deren Verbindungsstelle an den Eingang eines Komparators (A) angeschlossen ist, welcher die Spannung an besagter Verbindungsstelle mit einer Referenzspannung ($V_{REF}$) vergleicht und der Ausgang dieses Komparators (A) einerseits direkt an die Steuerorgane des ersten und vierten Schalters (CS, CS') angeschlossen ist und andererseits, durch einen Umkehrkreis ($I_o$), an die Steuerorgane der zweiten und dritten Schalter (CR) und (CR').

5. Schaltung nach Anspruch 4,
dadurch gekennzeichnet, dass sie ausserdem, jeweils in Serie mit dem zweiten und dritten Schalter (CR') und (CR) angeordnete Widerstände (R'e) und (Re) aufweist.

6. Schaltung nach einem der vorhergehenden Ansprüche,
dadurch gekennzeichnet, dass sie ausserdem einen zur Spule (B) parallelgeschalteten Begrenzer (E) aufweist.

7. Schaltung nach einem der vorhergehenden Ansprüche,
dadurch gekennzeichnet, dass sie eine erste Diode ($D_1$) aufweist, welche in die Verbindung zwischen einer ($S_1$) der beiden Steuerklemmen und der von der Diskriminiervorrichtung und dem die Spule (B) steuernden Umschaltkreis gebildeten Einheit angeordnet ist.

8. Schaltung nach einem der Ansprüche 4 bis 7, in dem die besagten steuerbaren Schalter (CS, CS', CR, CR') von einem ersten, zweiten, dritten und vierten Transistor ($TS_1$, $TS'_1$, $TR_1$, $TR'_1$) gebildet werden,
dadurch gekennzeichnet, dass :

- der erste Transistor ($TS_1$) vom Typ PNP ist und sein Sender durch eine zweite Diode ($D'_3$) an die erste Diode ($D_1$) angeschlossen ist,

- der dritte Transistor ($TR_1$) vom Typ PNP ist und sein Sender direkt an die erste Diode ($D_1$) angeschlossen ist,

- der zweite und vierte Transistor ($TS'_1$) und ($TR'_1$) vom Typ NPN sind und ihr Sender an die Steuerklemme ($S_2$) der Schaltung angeschlossen ist,

- die Kollektoren des ersten und dritten Transistors ($TS_1$) und ($TS'_1$) jeweils an die Enden der Spule (B) angeschlossen sind,

- die Kollektoren des zweiten und vierten Transistors ($TR_1$) und ($TR'_1$) jeweils durch die Widerstände ($R_9$, $R_{10}$) an die beiden Enden der Spule (B) angeschlossen sind,

- die Basis des ersten Transistors ($TS_1$) an die Verbindungsstelle der Widerstände ($R_1$, $R_2$) der besagten Spannungsteilerbrücke angeschlossen ist, sowie durch eine dritte Diode ($D'_2$) an den Kollektor des dritten Transistors ($TR_1$),

- die Basis des dritten Transistors ($TR_1$) durch einen Widerstand ($R_3$) an die Verbindungsstelle eines Widerstandes ($R_4$), der zugleich an die Diode ($D_1$) angeschlossen ist, mit einer Zenerdiode

(DZ$_1$) angeschlossen ist, deren Anode an die Steuerklemme (S$_2$) angeschlossen ist,

- die Basis des zweiten Transistors (TS'$_1$) an die Verbindungsstelle von zwei Widerständen (R$_7$) und (R$_8$) angeschlossen ist, welche eine Spannungsverteilerbrücke zwischen dem Kollektor des vierten Transistors (TR'$_1$) und der Steuerklemme (S$_2$) bilden,
- ein Kondensator (C) zum Widerstand (R$_8$) parallelgeschaltet ist.

9. Schaltung nach einem der Ansprüche 4 bis 8, dadurch gekennzeichnet, dass besagter Begrenzer (E) von vier Dioden (D$_4$, D$_5$, D$_6$) gebildet wird, die jeweils antiparallel zu den besagten ersten, zweiten, dritten und vierten Transistoren (TS$_1$, TS'$_1$, TR$_1$, TR'$_1$) geschaltet sind.

10. Schaltung nach Anspruch 1, zur Speisung und Steuerung einer bistabilen Zylinderspule mit zwei Spulen (BS, BR), dadurch gekennzeichnet, dass besagte beiden Spulen (B$_1$, B$_2$) an die Klemmen (S$_1$, S$_2$) der Schaltung angeschlossen sind, durch einen Umschaltkreis, welcher die eine oder die andere der Spulen (BS, BR) je nach dem Wert der an die Steuerklemmen (S$_1$, S$_2$) angelegten Impulse versorgen kann.

11. Schaltung nach Anspruch 10, dadurch gekennzeichnet, dass besagter Umschaltkreis zwei steuerbare Schalter (CS) und (CR) aufweist, die jeweils in Serie mit den Spulen (BS) und (BR) angeordnet sind, und dass besagte Steuerbare Schalter (CS) und CR) von einer Diskriminierschaltung gesteuert werden, welche eine Spannungsverteilerbrücke aufweist, die von zwei in Serie zwischen den beiden Steuerklemmen (S$_1$, S$_2$) angeordneten Widerständen (R$_1$, R$_2$) gebildet wird, deren Verbindungsstelle an den Eingang eines Komparators (A) angeschlossen ist, welcher die Spannung an besagter Verbindungsstelle mit einer Referenzspannung (V$_{REF}$) vergleicht, und der Ausgang dieses Komparators (A) einerseits direkt mit dem Steuerorgan eines der beiden steuerbaren Schalter (CS) verbunden ist und durch einen Umkehrkreis (I'$_0$) an das Steuerorgan des anderen steuerbaren Schalters (CR) angeschlossen ist.

12. Schaltung nach einem der Ansprüche 10 und 11, dadurch gekennzeichnet, dass eine Diode (D$_2$, D$_3$) zu jeder der Spulen (BR, BS) parallelgeschaltet ist.

13. Schaltung nach einem der Ansprüche 10 bis 12, dadurch gekennzeichnet, dass ein Widerstand (Re) mit der Spule (BR) in Serie geschaltet ist.

14. Schaltung nach einem der Ansprüche 10 bis 13, dadurch gekennzeichnet, dass sie eine Diode (D$_1$)aufweist, die in die Verbindung zwischen einer (S$_1$) der beiden Steuerklemmen und der von der Diskriminiervorrichtung und dem die Spulen (BS) und (BR) beaufschlagenden Umschaltkreis gebildeten Einheit angeordnet ist.

15. Schaltung nach einem der Ansprüche 10 bis 14, dadurch gekennzeichnet, dass die besagten beiden Spulen (BS) und (BR) durch zwei Transistoren (TS$_2$) und (TR$_2$) und eine gemeinsame Diode (D$_1$) an besagte Steuerklemmen angeschlossen sind, dass die Basis des Transistors (TS$_2$) durch einen Kondensator (C) an seinen Sender angeschlossen ist und durch einen Widerstand (R$_{10}$) an den Kollektor des Transistors (TR'$_1$), dass die Basis des Transistors (TR$_2$) an die Verbindungsstelle eines Widerstandes (R$_{13}$) angeschlossen ist, welcher an die Kollektoren der Transistoren (TS$_2$) und (TR$_2$) angeschlossen ist und einer an die Steuerklemme (S$_2$) angeschlossenen Zenerdiode (DZ$_2$) angeschlossen ist.

FIG.1

FIG. 2

FIG.3

14

## FIG.4

## FIG.5

## FIG.6

FIG.7

FIG.8

# FIG.9